# DEMANDE DE BREVET EUROPEEN

(11) **EP 0 565 464 A1**
(43) Date de publication de la demande: **13.10.1993**
(21) Numéro de dépôt: 93420149.2
(22) Date de dépôt: 07.04.1993
(51) Int. Cl.: G01R 29/10, H01Q 17/00

(54) **Procédé pour amortir des ondes électromagnétiques, notamment dans une enceinte de Faraday**

(30) Priorité: 07.04.1992 FR 9204476
(71) Demandeur: A.E.M.C., Société à Responsabilité Limitée, F-38180 Seyssins (FR)
(72) Inventeur: Charoy, Alain, F-38950 St Martin le Vinoux (FR)
(74) Mandataire: Thibault, Jean-Marc

(57) **Abrégé**

Le procédé selon l'invention pour amortir des ondes électromagnétiques consiste à interposer, sur la trajectoire des ondes, des câbles absorbants (5) composés chacun d'un conducteur électrique filaire (6) en contact, au moins partiellement sur sa longueur, avec un matériau ferrimagnétique (7) et à placer les câbles (5) à distance les uns des autres pour former des antennes assurant, par le conducteur (6), la circulation de courants induits qui se trouvent dégradés en chaleur par le matériau ferrimagnétique (7) et le conducteur électrique (6).

## Description

La présente invention concerne le domaine technique général des moyens conçus pour amortir des champs ou des ondes électromagnétiques dans l'environnement d'une enceinte au sens général.

L'invention vise, plus précisément, les moyens conçus pour amortir les ondes électromagnétiques à l'intérieur d'une chambre blindée, dénommée usuellement cage de Faraday, qui constitue une enceinte métallique protégeant son espace intérieur contre l'influence des corps électrisés extérieurs.

Il est connu d'utiliser une cage de Faraday pour permettre d'effectuer, à l'intérieur de son volume, des mesures précises de champs électromagnétiques engendrés par des appareils électroniques, tels que des émetteurs, et reçus par des récepteurs. Si l'utilisation d'une cage blindée permet de s'affranchir de l'action des champs électromagnétiques extérieurs à la cage, il apparaît que les ondes électromagnétiques émises par l'appareil sont réfléchies par les parois conductrices de la cage. Aux fréquences élevées, il s'ensuit l'apparition d'ondes stationnaires qui perturbent notablement la fiabilité des mesures.

En vue de remédier à un tel inconvénient, l'état de la technique a proposé diverses solutions pour réduire les réflexions des champs électromagnétiques sur les parois d'une cage, de manière à amortir les résonances qui en résultent.

Une première solution vise à placer, à l'intérieur de la chambre, des pyramides absorbantes composées de pointes de mousse en polyuréthane chargée de graphite. Pour conserver l'efficacité de cette solution à des fréquences inférieures à 50 MHz, il convient de réaliser des pyramides possédant une longueur supérieure à 3 mètres. L'absorption des ondes par des pyramides constitue une solution onéreuse qui réduit, au surplus, le volume utile de la cage de mesure.

Une autre solution connue consiste à poser des tuiles de ferrite contre les parois de la cage blindée. L'expérience pratique montre qu'un revêtement de tuiles est efficace uniquement en ce qui concerne les ondes électromagnétiques incidentes de direction sensiblement orthogonale aux parois. De plus, de telles tuiles imposent une surcharge sur les parois et présentent un coût unitaire élevé, limitant leur utilisation pour revêtir complètement l'intérieur d'une cage blindée.

L'objet de l'invention vise donc à proposer un procédé pour amortir des ondes électromagnétiques, ne présentant pas les inconvénients des solutions connues de l'art antérieur.

Pour atteindre un tel objectif, le procédé selon l'invention consiste à interposer, sur la trajectoire des ondes, des câbles absorbants composés chacun d'un conducteur électrique filaire en contact, au moins partiellement sur sa longueur, avec un matériau ferrimagnétique et à placer les câbles à distance les uns des autres pour former des antennes assurant, par le conducteur, la circulation de courants induits qui se trouvent dégradés en chaleur par le matériau ferrimagnétique.

Selon une caractéristique particulièrement avantageuse, le procédé selon l'invention consiste à placer les câbles absorbants à l'intérieur d'une cage de Faraday en vue de réduire la réflexion des ondes sur les parois de la cage.

Le procédé selon l'invention permet d'assurer l'amortissement des ondes électromagnétiques présentant une fréquence comprise entre 10 MHz et 300 MHz, sans toutefois imposer une surcharge aux parois de la cage. L'efficacité d'un tel procédé d'amortissement est indépendant de l'angle d'incidence des ondes électromagnétiques et son coût de mise en oeuvre est relativement réduit.

Diverses autres caractéristiques ressortent de la description faite ci-dessous en référence aux dessins annexés qui montrent, à titre d'exemples non limitatifs, des formes de réalisation de l'objet de l'invention.

La Fig. 1 est une vue partielle en perspective d'une cage de Faraday mettant en oeuvre le procédé d'amortissement selon l'invention.

La Fig. 2 est une vue en coupe en plan d'une cage de Faraday mettant en oeuvre une variante de réalisation du procédé d'amortissement selon l'invention.

La Fig. 3 est une vue d'un détail caractéristique du procédé selon l'invention.

Les Fig. 4 et 5 illustrent des variantes de montage des câbles absorbants à l'intérieur d'une cage de Faraday.

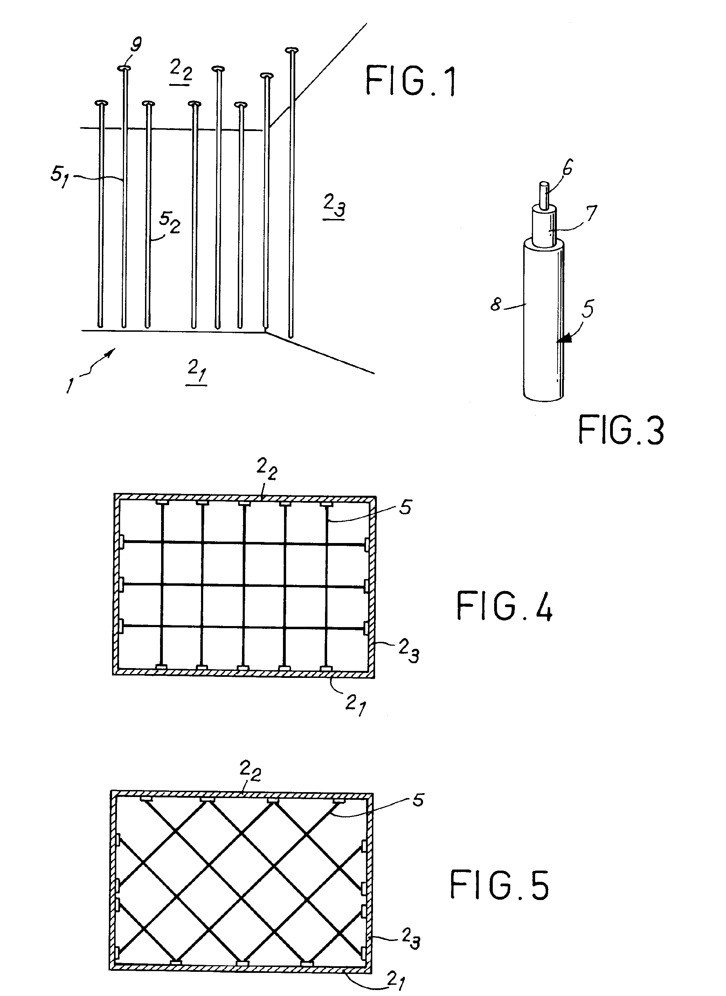

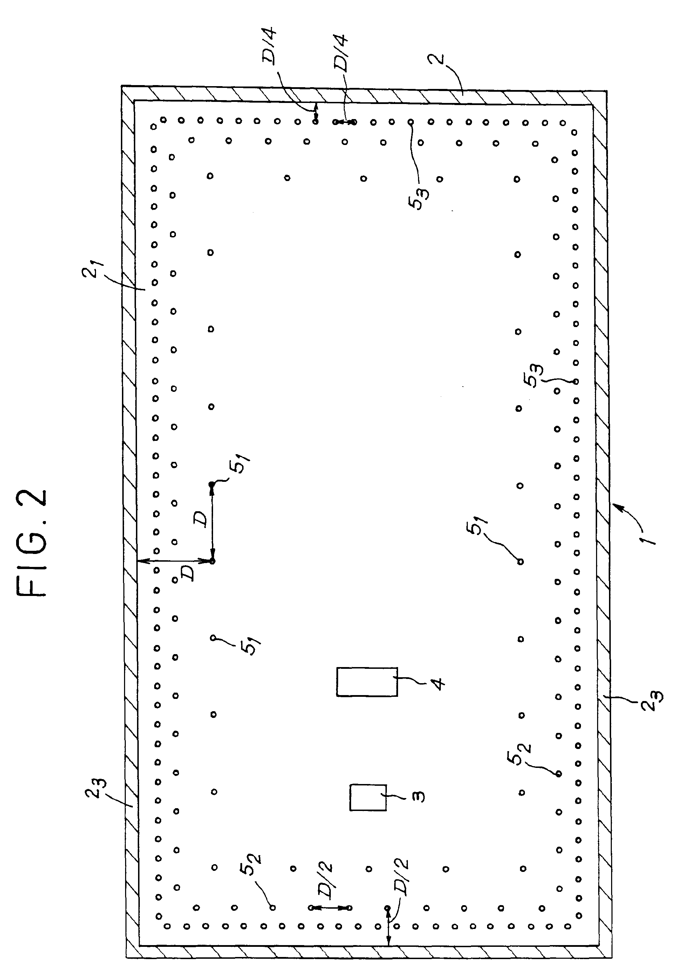

Les Fig. 1 et 2 illustrent un exemple d'application du procédé selon l'invention conçu pour amortir des ondes électromagnétiques à l'intérieurd'une enceinte 1 constituant, de préférence, une chambre blindée ou une cage de Faraday 1, de toute nature et de forme connues en soi. Dans l'exemple illustré sur les figures, la cage 1 présente une forme parallélépipèdique délimitée par des parois métalliques 2 composées d'un plancher 2₁, d'un plafond 2₂ et de quatre parois verticales 2₃. Selon une application de la cage, un émetteur 3 d'ondes électromagnétiques est placé à l'intérieur de la chambre 1, à une distance donnée d'un récepteur 4, de manière à permettre la mesure précise des champs électromagnétiques reçus.

Afin d'amortir la réflexion des ondes incidentes sur les parois métalliques 2 de la cage, le procédé selon l'invention consiste à interposer, sur la trajectoire des ondes, des câbles absorbants 5. Tel que cela apparaît, plus précisément, à la Fig. 3, chaque câble 5 est composé d'un conducteur électrique filaire 6 entouré par une couche d'un matériau ferrimagnétique 7, appelé usuellement ferrite. Dans l'exemple illustré, chaque câble comporte une gaine extérieure isolante 8, réalisée par exemple en polychlorure de vynile (PVC) ou en polytétrafluoroéthylène (PTFE).

Les câbles 5 sont placés à distance les uns des autres à proximité des parois 2, de manière à former chacun, une antenne assurant, par le conducteur 6, la circulation de courants induits qui se trouvent dégradés en chaleur par le matériau ferrimagnétique 7 et le conducteur électrique 6. L'interposition des câbles absorbants 5 sur la trajectoire des ondes permet de réduire la réflexion des ondes sur les parois 2 de la cage et, par suite, d'amortir les phénomènes de résonance à l'intérieur de la chambre.

L'expérience pratique montre que l'utilisation de câbles absorbants, commercialisés sous la dénomination MUSORB, donne de bons résultats. Bien entendu, il peut être envisagé d'utiliser un câble absorbant différent constitué, par exemple, par un tube conducteur électrique à l'extérieur duquel est placé un matériau ferrimagnétique. De même, il peut être prévu que le matériau ferrimagnétique 7 ne se trouve pas en contact avec le conducteur 6 sur toute sa longueur, mais uniquement de manière localisée, par l'intermédiaire de perles de ferrite réparties le long du conducteur 6. D'une manière générale, il convient d'utiliser un matériau ferrimagnétique 7 aussi peu conducteur de l'électricité que possible pour permettre aux champs hautes fréquences de pénétrer en volume. Le matériau 7 doit présenter des pertes magnétiques aussi fortes que possible, c'est-à-dire posséder une perméabilité magnétique imaginaire notée f..l" aussi grande que possible. De préférence, le matériau 7 est constitué de grains de ferrite possédant une longueur moyenne au moins égale à 200 f..lm. De même, le matériau magnétique doit présenter une forte concentration, telle que par exemple 80 % en volume de ferrite et 20 % de liant.

Selon une caractéristique avantageuse du procédé d'amortissement selon l'invention, les câbles absorbants 5 sont organisés de manière à permettre un amortissement des ondes dans une gamme de fréquence variant de 10 à 300 MHz.

Tel que cela apparaît plus précisément à la Fig. 2, il est prévu de former un premier réseau de câbles 5₁ séparés deux à deux d'une mesure donnée D et placés à une distance des parois, sensiblement égale à la mesure D, tout en suivant un profil donné de la cage. Dans l'exemple illustré, les câbles 5₁ du premier réseau suivent la section droite transversale rectangulaire de la cage en s'étendant à une distance D des parois verticales 2₃ de la cage. A titre d'exemple préféré mais non limitatif, la mesure d'écartement D entre les câbles et entre ces câbles et la paroi est de l'ordre de 1 mètre. Un tel réseau de câbles 5₁ permet ainsi d'amortir les ondes présentant une fréquence de l'ordre de 30 MHz. Dans l'exemple illustré aux Fig. 1 et 2, les câbles 5₁ s'étendent sensiblement parallèlement les uns aux autres, selon une direction verticale en étant fixés uniquement au plafond 2₂ de la cage, par l'intermédiaire de tous moyens de fixation 9 connus en soi. Les câbles s'étendent, de préférence, du plafond 2₂ jusqu'au niveau du plancher 2₁. Le conducteur électrique 6 de chaque câble est monté, de préférence, pour être relié électriquement au plafond 2₂ à l'aide des moyens de fixation 9 conducteurs, en vue de permettre la circulation des courants induits sur les parois de la cage. Il est à noter qu'il peut être prévu aussi de procéder à un montage isolant ou conducteur des deux extrémités des câbles sur les parois 2.

Selon une caractéristique avantageuse, les câbles absorbants montés à l'intérieur de la cage sont organisés pour former, additionnellement au premier réseau, un deuxième réseau de câbles absorbants 5₂ séparés deux à deux d'une mesure sensiblement égale à D/2 et placés à une distance des parois de la cage sensiblement égale à cette mesure D/2 en suivant le même profil de la cage que celui suivi par le premier réseau de câbles 5₁. Dans l'exemple illustré, les câbles absorbants 5₂ sont montés sensiblement pour s'étendre parallèlement les uns aux autres suivant une direction verticale et en étant fixés au plafond 2₂. A titre d'exemple, les câbles absorbants 5₂ sont distants deux à deux d'une distance de l'ordre de 0,5 mètre et se trouvent placés, également, à une distance sensiblement de l'ordre de 0,5 mètre des parois verticales 2₃ de la cage. Selon cette disposition, le réseau de câbles 5₂ permet d'obtenir un amortissement des ondes qui présente une fréquence de l'ordre de 150 MHz.

Selon une variante de réalisation, il peut être prévu d'organiser les câbles absorbants à l'intérieur de la cage pourformer un troisième réseau de câbles absorbants 5₃ séparés deux à deux d'une mesure sensiblement égale à D/4 et placés à cette distance D/4 des parois verticales 2₃ de la cage. Dans l'exemple illustré à la Fig. 2, les câbles 5₃ s'étendent parallèlement les uns aux autres suivant une direction verticale. A titre d'exemple, les câbles absorbants 5₃ sont séparés deux à deux d'une distance de l'ordre de 0,25 mètre et se trouvent situés à cette distance des parois verticales 2₃ de la cage. Une telle disposition permet d'assurer l'amortissement des ondes électromagnétiques qui présentent une fréquence de l'ordre de 300 MHz.

La mise en oeuvre de trois réseaux de câbles absorbants (5₁, 5₂, 5₃) permet ainsi d'obtenir une gamme d'absorption en fréquence des ondes électromagnétiques incidentes. Dans l'exemple illustré, les câbles absorbants assurent l'amortissement des ondes se propageant verticalement. Bien entendu, il peut être prévu de placer les câbles absorbants selon une direction horizontale pour assurer l'absorption des champs horizontaux.

Tel que cela apparaît plus précisément à la Fig. 4, il peut être prévu de disposer les câbles absorbants de chaque réseau, de manière qu'ils s'entrecroisent, sans contact, selon deux directions sensiblement perpendiculaires. Tel que cela apparaît plus précisément à laFig. 4, les câbles absorbants 5 de chaque réseau comportent une série de câbles s'étendant verticalement, sensiblement parallèlement aux parois 2₃ et une seconde série de câbles s'étendant horizontalement, selon une direction parallèle au plancher 2₁ et au plafond 2₂. Une telle disposition permet d'assurer l'amortissement des ondes se propageant selon des directions horizontales et verticales.

Tel que cela apparaît plus précisément à la Fig. 5, il peut être prévu de disposer les câbles absorbants 5 de chaque réseau, de manière qu'ils s'étendent selon deux directions perpendiculaires, tout en étant inclinés par rapport au plafond 2₂ de manière à permettre d'amortir les réflexions en polarisation croisée.

Selon une caractéristique avantageuse, qui apparaît plus précisément à la Fig. 2, les câbles absorbants 5₁, 5₂, 5₃ des réseaux se trouvent décalés de manière symétrique, d'un réseau à l'autre, par rapport à une direction normale à la paroi. Une telle disposition offre l'avantage d'augmenter la probabilité que les câbles absorbants se trouvent sur la trajectoire des ondes quelle que soit leur direction par rapport aux parois de la cage.

Le procédé selon l'invention présente un coût de mise en oeuvre très inférieur aux solutions connues de l'état de la technique. De plus, son efficacité est indépendante de l'angle d'incidence des modes électromagnétiques. Les parois de la cage de Faraday ne subissent, par ailleurs, aucune contrainte mécanique.

Le procédé selon l'invention peut être mis en oeuvre dans toute application nécessitant de limiter les ondes stationnaires dans l'environnement d'une enceinte, au sens général, relevant par exemple du milieu industriel (atelier, central téléphonique) ou du milieu médical (bloc opératoire, salle d'analyse). Par ces applications, il est prévu d'interposer, sur la trajectoire des ondes, des câbles absorbants conformes à l'invention.

L'invention n'est pas limitée aux exemples décrits et représentés, car diverses modifications peuvent y être apportées sans sortir de son cadre.

## Revendications

1 - Procédé pour amortir des ondes électromagnétiques, caractérisé en ce qu'il consiste à interposer, sur la trajectoire des ondes, des câbles absorbants (5) composés chacun d'un conducteur électrique filaire (6) en contact, au moins partiellement sur sa longueur, avec un matériau ferrimagnétique (7) et à placer les câbles (5) à distance les uns des autres pourformer des antennes assurant, par le conducteur (6), la circulation de courants induits qui se trouvent dégradés en chaleur par le matériau ferrimagnétique (7) et le conducteur électrique (6).

2 - Procédé selon la revendication 1, caractérisé en qu'il consiste à placer les câbles absorbants (5) à l'intérieur d'une enceinte (1), en vue de réduire la réflexion des ondes incidentes sur les parois (2) de l'enceinte.

3 - Procédé selon la revendication 2, caractérisé en ce qu'il consiste à organiser les câbles absorbants pour former au moins un premier réseau de câbles (5₁) séparés deux à deux d'une mesure donnée (D) et placés à une distance des parois sensiblement égale à la mesure (D), en suivant un profil donné de l'enceinte (1).

4 - Procédé selon la revendication 3, caractérisé en ce qu'il consiste à organiser les câbles absorbants pour former, additionnellement au premier réseau, un deuxième réseau de câbles absorbants (5₂) séparés deux à deux d'une mesure sensiblement égale à D/2 et placés à une distance des parois sensiblement égale à la mesure D/2 en suivant le même profil de l'enceinte que celui suivi par le premier réseau.

5 - Procédé selon les revendications 3 et 4, caractérisé en ce qu'il consiste à organiser les câbles absorbants pour former, additionnellement aux premier et deuxième réseaux, un troisième réseau de câbles absorbants (5₃) séparés deux à deux d'une mesure sensiblement égale à D/4 et placés à une distance des parois sensiblement égale à la mesure D/4, en suivant le même profil de l'enceinte que celui suivi par le premier et le deuxième réseaux.

6 - Procédé selon l'une des revendications 3 à 5, caractérisé en ce qu'il consiste à placer les câbles absorbants (5₁, 5₂, 5₃) de chaque réseau, de manière qu'ils s'étendent sensiblement parallèlement les uns aux autres.

7 - Procédé selon l'une des revendications 3 à 5, caractérisé en ce qu'il consiste à placer les câbles absorbants (5₁, 5₂, 5₃) de chaque réseau, de manière qu'ils s'entrecroisent sans contact, selon deux directions sensiblement perpendiculaires.

8 - Procédé selon la revendication 6 ou 7, caractérisé en ce qu'il consiste à placer les câbles absorbants (5₁, 5₂, 5₃) des trois réseaux, de manière qu'ils se trouvent décalés, de manière symétrique, d'un réseau à l'autre, par rapport à une direction normale à la paroi.

9 - Procédé selon l'une des revendications 2 à 8, caractérisé en ce qu'il consiste à relier, électriquement aux parois (2) de l'enceinte, au moins l'une des extrémités des conducteurs de certains des câbles absorbants.

10 - Enceinte, caractérisée en ce qu'elle comporte intérieurement des câbles absorbants (5) disposés selon le procédé conforme à l'une des revendications 1 à 9.
